# EUROPÄISCHE PATENTANMELDUNG

(11) **EP 0 831 684 A2**
(43) Veröffentlichungstag der Anmeldung: **25.03.1998**
(21) Anmeldenummer: 97116569.1
(22) Anmeldetag: 23.09.1997
(51) Int. Cl.: H05K 7/14

(54) **Verpackung für Leistungselektronik**

(30) Priorität: 23.09.1996 DE 19638996; 22.10.1996 DE 19643671; 04.12.1996 DE 19650318
(71) Anmelder: D-Tech GmbH Antriebstechnik und Mikroelektronik, 33689 Bielefeld (DE)
(72) Erfinder: Gabriel, Rupprecht, 33689 Bielefeld (DE)
(74) Vertreter: Leonhard, Frank Reimund, Dipl.-Ing.

(57) **Zusammenfassung**

Das technische Gebiet der Erfindung ist die Verpackung von Leistungselektronik, die schnell, sicher und kostengünstig erfolgen soll. Vorgeschlagen wird dazu eine Verpackung für eine auf einer Trägerfläche (50;50i;50p) angeordnete Schaltung der Leistungselektronik (60), welche Verpackung einen tiefgezogenen hutförmigen Deckel (10) und einen flachen wannenförmigen Rumpf (20) aufweist, die randseitig (20a,20b) durch Umfalzen oder Bördeln (B) eines am Deckelrand angebrachten Falzrandes (10a,10b) um den Rand (20b) der Rumpfwanne (20) verschlossen ist. Die so gebildete "Verpackung" ist dem Sinne nach ein Gehäuse, bei dem der Rumpf flach ist und der Deckel eine der Höhe der Bauteile oder vertikal eingesetzten Platinen entsprechende Dimension hat.

## Beschreibung

Das technische Gebiet der Erfindung ist die Verpackung von Leistungselektronik, die schnell, sicher und kostengünstig erfolgen soll.

Mit der Erfindung wird das dann erreicht, wenn eine metallische Verpackung aus einem tiefgezogenen hutförmigen Deckel und einem flachen wannenförmigen Rumpf vorgesehen wird, die randseitig durch bördeln oder umfalzen verschlossen werden (Anspruch 1). Dabei hat sich gezeigt, daß nicht Standardgehäuse oder ein mit Einsteckplatten und Schienen ausgestattetes Baukastensystem-Gehäuse für die Verpackung eines Wechselrichters oder Umrichters in der Starkstromtechnik sinnvoll ist, sondern eine nach Art einer Konservendose verschlossene Verpackung, deren Falzrand nahe der Ebene der Leistungselektronik verläuft, was durch den flachen wannenförmigen Rumpf zum Ausdruck gebracht werden soll (Anspruch 6), in den der Hauptaufbau und die Hauptverdrahtung der Leistungselektronik gelegt wird ("Platine"). Es hat sich dabei auch gezeigt, daß die elektrische Abschirmung eines so verpackten Wechselrichters um ein Vielfaches günstiger ist und Störstrahlung aufgrund des Schaltens der Leistungshalbleiter mit hoher Frequenz in geringerem Maße nach außen dringt, als wenn übliche Gehäuse verwendet werden.

Der Falzrand des hutförmigen Deckels kann L-förmig ausgebildet sein (Anspruch 2), wobei der seitlich abragende Schenkel des L-förmigen Falzrandes beim Verschließen auf dem ebenfalls seitlich als Auflage abragenden Rand der Rumpfwanne (Anspruch 3) aufliegt. Der verbleibende vertikale Restschenkel des L-förmigen Anlageschenkels des hutförmigen Deckels wird dann zu einem Einfachfalz mit einer flächengepreßten Klemmung umgebördelt (Anspruch 4), so daß die dosenähnliche Verpackung in Form eines rechteckförmigen Behältnisses aus tiefgezogenem Metallblech entsteht, die umlaufend eine Falznaht hat, die nahe bei dem Hauptaufbau der Leistungselektronik liegt.

Aufgrund des hutförmigen Deckels können weitere Platinen mit zusätzlichen Komponenten in eine Richtung vertikal zu der Ebene des Leistungselektronik-Hauptaufbaus angebracht werden, um am oberen Ende dieser vertikalen Zusatzplatinen (Anspruch 9) elektrische Anschlüsse vorzusehen, die durch Öffnungen an der Oberseite des hutförmigen Deckels hindurchtreten. Hier erfolgen die Anschlüsse des Starkstroms, einmal Eingangsspannung und Ausgangsspannung, ggf. auch Zwischenkreis-Spannung, also der Anschluß des Speisenetzes und der Anschluß der zu steuernden Maschine.

Die Hauptebene der Leistungselektronik (Anspruch 10) ist so in den flachen wannenförmigen Rumpf eingesetzt, daß sie dort eine gute Kühlwirkung zum Boden des Rumpfes ermöglicht. Dazu kann eine thermisch leitende dickere Platte vorgesehen werden, die zum Beispiel aus Kupfer gefertigt sein kann, und auf der über isolierende Inseln die Leistungselektronik-Komponenten (Leistungsdioden, Leistungstransistoren, GTOs, sonstige gebräuchliche Leistungshalbleiter) isolierend befestigt sein können, umgeben von einer die elektrischen Verbindungen der Steuerung ermöglichenden Platine, die flexibel ausgestaltet sein kann. Verbindungen von und zu den Leistungshalbleitern werden mit Bonddrähten ausgeführt, die zu seitlich angeordneten Verbindungsstiften führen, von denen dickere Verbindungsleitungen direkt zu den oben erwähnten Anschlußklemmen gelegt sind (in vertikaler Richtung) oder die über die seitlich vertikal stehenden Zusatzplatinen nach oben herausgelegt sind.

Die Führung der Steuerströme und Meßströme kann über die oben erwähnte flexible Platine erfolgen, die Leiterbahnen trägt und die ausgeschnittene Öffnungen aufweist, durch die die Leistungshalbleiter, die direkt am Boden der Wanne oder an der Kupferplatte befestigt sind, hervorstehen. Auch diese Leiterbahnen können aber direkt am Boden der Rumpfwanne befestigt werden, wenn eine isolierende Klebschicht, die Harzcharakter hat, als Zwischenschicht verwendet wird, um sowohl Befestigungsfunktion als auch Isolierfunktion zu übernehmen. Dann ist eine gesonderte Isolierplatine nicht erforderlich und der gesamte Aufbau der Leistungselektronik mit Steuerströmen und Lastströmen kann direkt auf der Bodenfläche der Wanne angebracht sein.

Wärmeleitung zum Kühlkörper am Boden der tiefgezogenen Verpackung aus Blech wird mit einer lose eingefüllten Sand/Polymer-Mischung erreicht (Anspruch 7, Anspruch 8).

Die Erfindung(en) werden nachfolgend anhand mehrerer Ausführungs**beispiele** erläutert und ergänzt.
- **Figur 1**: ist eine Seitenansicht eines Behältnisses aus tiefgezogenem Metallblech mit hutförmigem Deckel 10 und flacher Wanne 20 als Rumpf und einem umlaufenden Bördelrand B.
- **Figur 2**: ist eine Aufsicht auf die Verpackung gemäß Figur 1, in der die linke Hälfte mit der durch eine langgestreckte Öffnung 40 zugängliche Anschluß-Klemmenleiste 52 dargestellt ist und ein Teil der dazu senkrecht verlaufenden Anschlußleiste 42 gezeigt ist, die durch eine weitere Öffnung 41 im hutförmigen Deckel 10 zugänglich ist, um Steuerströme, Meßströme und andere Signale zuführen und abnehmen zu können.
- **Figur 3**: ist eine vergrößerte Teilansicht des Randbereiches der Ebene der Leistungselektronik von Figur 1, in der der aus drei Blechlagen bestehende Falzrand B verdeutlicht wird, dessen Umfalzen mit dem Richtungsvektor F symbolisiert wird.
- **Figur 4a**, **Figur 4b**: sind zwei Aufbauten in der Leistungselektronik-Ebene, einmal mit einer Kupferplatte 30 als mechanisch festem Träger des Leistungsaufbaus und einmal mit einer direkten Anbringung der Leistungselektronik-Komponenten 60 und der Leiterbahnführung auf dem Boden 20d der Rumpfwanne 20.

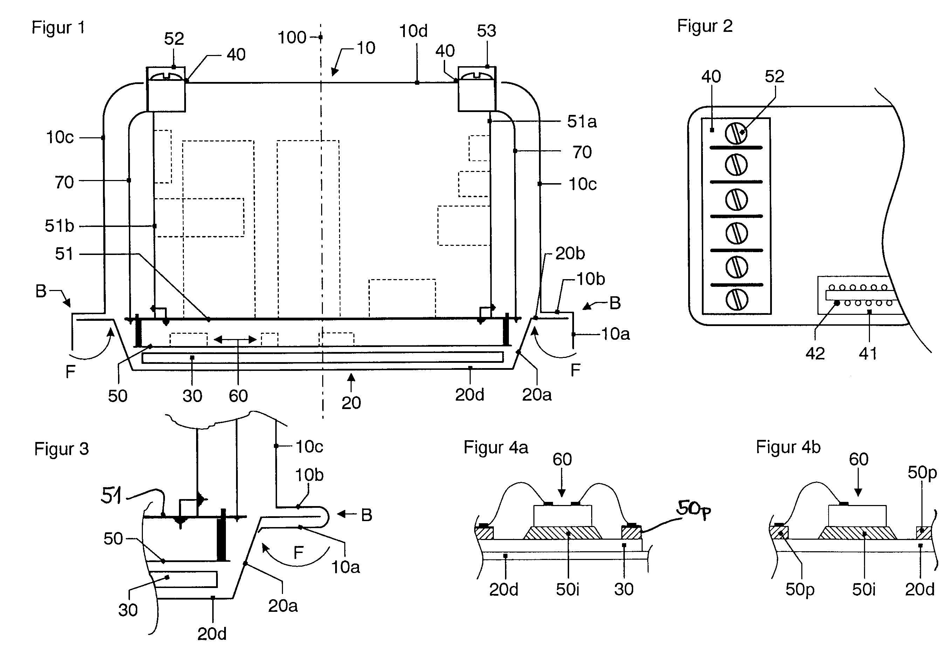

**Figur 1** ist eine im Schnitt gezeigte Seitenansicht des Behälters 10 mit einem hutförmigen Deckel, der eine obere Fläche 10d hat und vier Seitenwände 10c, die vertikal ausgerichtet sind. Am Ende dieser Seitenwände ist ein L-förmiger (umlaufender) Falzschenkel 10b, 10a vorgesehen, dessen horizontaler Abschnitt 10b auf einem Auflageschenkel 20b der flachen Rumpfwanne 20 aufliegt. Beim Aufsetzen des Deckels 10 - beim Überstülpen des hutförmigen Deckels über die mit einem Platinenaufbau 50,51 und den dazugehörigen vertikalen Zusatzplatinen 51a,51b bestückten Wannenboden 20 - gleitet der vertikale Schenkel 10a am Ende des horizontalen Schenkels 20b der Bodenwanne vorbei. Das Ende des Aufsetzens wird erreicht, wenn das horizontale Schenkelpaar 10b, 20b aufeinander aufliegt. Dann wird in Richtung des Pfeiles F ein Umfalzen umlaufend ausgeführt, so daß ein Einfachfalz randseitig entsteht, der gleichzeitig eine elastische Vorspannung von oben auf die Platinen 50,51a,51b,51 ausüben kann, wenn eine entsprechende Berührungsstelle der horizontalen Deckelplatte 10d an den vertikalen Platinen oder an den isolierten Anschlußklemmen 52, 53, die durch die Deckelwand 10d ragen, ermöglicht wird.

Im flachen Wannenbereich (umgeben von dem Wannenrand 20a, von dem der horizontale Auflageschenkel 20b nach außen gerichtet absteht) ist auf dem Wannenboden 20d die Ebene der Leistungselektronik (Leistungshalbleiter, Leistungsdioden und Verbindungsschaltungen) ausgeführt, wobei die **Figuren 4a und 4b** Möglichkeiten zeigen, wie dieser Aufbau im Detail aussehen kann, welcher Aufbau allgemein mit "Platine" bezeichnet wird, um zum Ausdruck zu bringen, daß hier an sich eine Platine mit Bauelementen vorgesehen sein könnte, diese Platine aber nicht mehr zwingend eine Epoxyd-Basis und eine darauf angebrachte Leiterbahnführung hat, sondern teilweise thermisch leitend, teilweise elektrisch isolierend und im Detail in mehreren Lagen aber im wesentlichen einer Ebene ausgebildet ist.

**Figur 4a** verdeutlicht dabei die Anbringung auf einer Kupferplatte 30, die auch in **Figur 1** als Zwischenlage zu "Platine 50" , auf der die Leistungselektronik-Komponenten 60 schematisch dargestellt sind, ersichtlich ist. Diese mechanisch stabile Platte 30, die wärmeleitend ist, ist auf dem Boden 20d der Wanne 20 aufgelegt. Es kann eine Zwischenschicht zum elastischen Ausgleich von Unebenheiten und zur Vermeidung des Entstehens von Gasblasen im thermisch leitenden Pfad vorgesehen sein. Auf der leitenden Platte 30 ist eine Struktur vorgesehen, die aus einer flexiblen Platine besteht, die Inselöffnungen aufweist, durch die die Leistungshalbleiter 60 ragen, die auf eigenen Isolierinseln 50i fest an der Kupferplatte 30 befestigt sind. Die flexible Leiterbahnführung 50p ermöglicht die Zuführung der Steuerströme und Signalströme zu den Leistungshalbleitern, während die Leistungsströme über Bonddrähte direkt zu randseitigen dickeren Verbindungsleitungen 70 in Figur 1 geführt werden, um zu den Leistungs-Anschlußklemmen 52, 53 zu gelangen. Die Platine 50p ist also isoliert, liegt aber lose oder leicht befestigt nur auf der Kupferplatte 30 auf, während ein jeweiliger Leistungshalbleiter 60 über eine Isolationsinsel 50i aus einer isolierenden Klebstoffschicht fest und dauerhaft an der Kupferplatte 30 angebracht sind.

**Figur 4b** zeigt den direkten Aufbau der Leistungshalbleiter 60 auf dem Boden 20d der Rumpfwanne 20, auch durch eine isolierende Schicht 50i, die inselförmigen Charakter hat, jeweils bezogen auf den Leistungshalbleiter 60, den sie elektrisch von der Bodenfläche 20d isolieren soll, den sie aber thermisch leitend mit dieser Bodenfläche 20d verbindet. Die Leiterbahnführung auf einer flexiblen, im wesentlichen zusammenhängenden Platine 50p mit Öffnungen für die Inseln ist in der Ausschnittsvergrößerung um die Leistungshalbleiter-Insel 50i herum angedeutet; sie umgibt so den anzusteuernden Leistungshalbleiter.

In Ergänzung zu der **Figur 4a** kann die lose oder leicht befestigte flexible (dünne) Platine 50p auch so ausgebildet werden, daß sie durch eine der isolierenden Klebstoffschicht 50i des Leistungshalbleiters 60 ähnliche Isolierschicht ersetzt wird, die dann direkt auf der Kupferplatte 30 oder direkt gemäß **Figur 4b** auf dem Boden 20d der Rumpfwanne angebracht sein kann. Dann sind sowohl die Leistungshalbleiter 60 über die isolierenden Inseln 50i, als auch die Leiterbahnführung über die Isolierschichten direkt am Boden 20d der Rumpfwanne angebracht und erlauben ein kostengünstigen, wenig auftragenden und thermisch direkt mit dem Boden verbundenen Aufbau.

**Figur 3** verdeutlicht den Randbereich des im Detail in den **Figuren 4a und 4b** gezeigten Aufbaus der "Platine 50", wobei die Kupferplatte 30 dargestellt ist, die mechanisch festigende und thermisch leitende Eigenschaften zum Boden 20d der Rumpfwanne hat. Ein leicht nach auswärts geneigter Verbindungsschenkel 20a leitet von dem Boden 20d in den horziontalen Auflageschenkel 20b des Rumpfwannen-Randes über, der zur Bildung des Verschlußfalzes 10b, 20b, 10a dient. Die Kraftwirkung des Umfalzens auf den Schenkel 10a ist mit F symbolisiert. Der Schenkel 10a kann etwas länger sein als der Auflageschenkel 20b, um innen eine klemmende Wirkung am Verbindungsschenkel 20a zu erreichen.

In **Figur 2** ist die Aufsicht gezeigt, die durch Öffnungen auf der oberen Platte 10d des hutförmigen Deckels 10 den Zugang zu den Anschlußklemmen 52 erlaubt, die hohe Ströme übertragen. Die Öffnung 40 ist dabei rechteckig ausgebildet und etwas größer gestaltet, als die Kunststoffisolation oder ein Isolierblock der Anschlußklemmen 52, die in der **Figur 1** teilweise über die im Durchmesser starken Verbindungsleitungen 70 zu der Leistungselektronik-Ebene 50 in der Rumpfwanne 20 geführt werden, die aber auch zu den vertikal stehenden Platinen 51a,51b mit ihren Leiterbahnen Verbindung haben können.

Die Steuerungstechnik und die Meßwerterfassung erfolgt durch eine weitere langgestreckte Öffnung 41 im Deckelpanel 10d, durch die ein Vielfach-Verbindungsstecker 42 für Schwachstrom hindurchragen kann. Diese Öffnung ist gemäß **Figur 2** senkrecht zu den beiden randseitig angeordneten Leistungselektronik-Öffnungen 40 in der Deckelfläche 10d angebracht.

Eine Mischung aus Sand und einem Polymer als Bindemittel kann in der Verpackung lose eingefüllt sein, bevor der Falzrand B verschlossen wird. Dadurch wird eine gesamte thermische Leitfähigkeit hergestellt, die alle Bauelemente einigermaßen wärmeleitend mit den metallischen Außenflächen des dosenartigen Gehäuses verbindet. Zusätzlich können in diese Mischung aus Sand und Polymer elastische Partikel eingefügt werden, die eine elastische Vorspannung auf alle Bauelemente und damit eine mechanische Festlegung beim Verschließen des Bördelrandes B erlauben.

Die Mischung aus Sand und Polymer besteht hauptsächlich aus Sand und hat maximal 65% Gewichtsbestandteile davon. Es können bis zu 30% Bindemittel in Form des erwähnten Polymers und etwa 5% der elastischen Partikel vorgesehen sein, wobei die Definition von etwa 5% ein Bereich von 0 bis 10% (insbesondere um 5% herum) dieser elastischen Partikel umschreiben soll, der Rest wird mit Sand oder Polymer aufgefüllt.

Zum Einfüllen dieser (thermisch leitenden aber elektrisch isolierenden) Füllstoffe wird empfohlen, zuerst den Sand, ggf. zusammen mit den elastischen Partikeln einzufüllen und dann das Polymer nachträglich einzubringen.

Das technische Gebiet der Erfindung ist die Verpackung von Leistungselektronik, die schnell, sicher und kostengünstig erfolgen soll. Vorgeschlagen wird dazu eine Verpackung für eine auf einer Trägerfläche (50;50i;50p) angeordnete Schaltung der Leistungselektronik (60), welche Verpackung einen tiefgezogenen hutförmigen Deckel (10) und einen flachen wannenförmigen Rumpf (20) aufweist, die randseitig (20a,20b) durch Umfalzen oder Bördeln (B) eines am Deckelrand angebrachten Falzrandes (10a,10b) um den Rand (20b) der Rumpfwanne (20) verschlossen ist. Die so gebildete "Verpackung" ist dem Sinne nach ein Gehäuse, bei dem der Rumpf flach ist und der Deckel eine der Höhe der Bauteile oder vertikal eingesetzten Platinen entsprechende Dimension hat.

## Patentansprüche

1. **Verpackung** für eine auf einer Platine (50;50i;50p) angeordnete Schaltung der Leistungselektronik (60), welche Verpackung einen tiefgezogenen hutförmigen Deckel (10;10a,10b,10c) und einen flachen wannenförmigen Rumpf (20) aufweist, die randseitig durch Umfalzen oder Bördeln (F) eines am Deckelrand angebrachten Falzrandes (10a,10b) um den Rand (20b) der Rumpfwanne (20) verschlossen ist (B).

2. Verpackung nach Anspruch 1, bei der der Falzrand des Deckels (10) L-förmig (10a,10b) ist, mit einem seitlich abragenden Anlageschenkel (10b) und einem sich daran anschließenden axial (100) gerichteten Falzschenkel (10a).

3. Verpackung nach Anspruch 2, bei der der Anlageschenkel (10b) so gestaltet ist, daß er nach Überstülpen des Deckels (10;10a,10b,10c) über die Schaltung (50,60) und nach Vorbeigleiten des Falzschenkels (10a) des Deckelrandes (10a,10b) an dem Rand (20b) der Rumpfwanne (20) flach auf einem seitlich abragenden Auflagerand (20b) der Rumpfwanne aufliegt.

4. Verpackung nach einem der vorigen Ansprüche, bei der der Falz ein Einfachfalz (B) ist, insb. nur aus der flächengepreßten Klemmung einer oberen Deckelrandlage, einer Rumpflage und einer unteren Deckelrandlage (10b,20b,10a) besteht.

5. Verpackung nach einem der vorigen Ansprüche, bei der der Deckel (10) und der Rumpf (20) aus Blech, insb. Aluminium- oder Stahlblech tiefgezogen gefertigt ist.

6. Vorrichtung nach einem der vorigen Ansprüche, bei der die Bodenwanne (20) flach ist und eine leitende dickere Platte (30) aufnimmt.

7. Verpackung nach einem der vorigen Ansprüche, bei der eine Mischung aus Sand und einem Polymer als Bindemittel in der Verpackung lose eingefüllt ist, insb. enthaltend etwa 0% bis 10% elastische Partikel, wie Gummigranulate.

8. Verpackung nach Anspruch 7, bei der mehr Sand als Polymer (Kunststoff) enthalten ist und erst der Sand und dann das Polymer eingefüllt wird, wobei maximal 65% Sand, 30% Bindemittel und etwa 5% elastische Partikel enthalten sind.

9. Verpackung nach einem der vorigen Ansprüche, bei der im Deckel (10) auf dessen oberer Flachseite (10d) Öffnungen (40,41) vorgesehen sind, durch die zumindest zwei elektrische Anschlußklemmenleisten (52,53;42) erreichbar sind, um Starkstrom und Steuerströme getrennt zuführen zu können.

10. Verpackung nach einem der vorigen Ansprüche, bei der
(a) als elektrisch isolierende Platine (50) Leistungselektronik-Komponenten (60) - umgeben von einem flexiblen Leiterbahnträger (50p) - elektrisch isoliert aber thermisch leitend (50i) fest an einer dickeren Platte (30) und diese am Boden (20d) der Rumpfwanne (20) elastisch angepresst ist; oder
(b) ein Mehrlagen-Bodenaufbau dadurch gebildet wird, daß direkt auf dem Boden (20d) des wannenförmigen Rumpfes (20) eine thermisch leitende aber elektrisch isolierende Klebstoffschicht (50i;50p) aufgebracht ist, um Leiterbahnführungen und zu kühlende Halbleiter (60) fest am Boden (20d) des Rumpfes anzubringen und gleichwohl elektrisch zu isolieren.

11. Verpackung nach Anspruch 10, bei der am Boden (20d) der Bodenwanne (20) ein Kühlkörper außenseitig thermisch leitend angebracht ist.

12. Verpackung nach Anspruch 10 oder 11, bei der die Klebstoffschicht (50i) inselweise dort vorgesehen ist, wo ein Leistungshalbleiter (60) am Wannenboden (20d) direkt oder über die dickere Platte (30) indirekt angebracht ist.

13. Verpackung nach Anspruch 12, bei der die elektrisch isolierenden Inseln (50i) umgeben sind von einem - weitgehend zusammenhängenden, mit Öffnungen für die Inseln ausgestatteten - flexiblen Leiterbahnträger (50p), der oberseitig Leiterbahnen trägt und unterseitig auf dem Wannenboden (20d) oder der dickeren Platte (30) anliegend angebracht ist.
